# EUROPEAN PATENT APPLICATION

(11) **EP 3 716 481 A1**
(43) Date of publication of application: **30.09.2020**
(21) Application number: 19166232.9
(22) Date of filing: 29.03.2019
(51) Int. Cl.: H03J 5/24, H03B 5/12

(54) **TUNING CELL FOR CAPACITIVELY TUNING DIGITALLY-CONTROLLED OSCILLATOR CORE**

(71) Applicant: INTEL Corporation, Santa Clara, CA 95054 (US)
(72) Inventor: REINHOLD, Sebastian, 81825 Munich (DE); BROUSSEV, Svetozar, 4040 Linz (AT); PAPAGEORGIOU, Vasileios, 84028 Landshut (DE)
(74) Representative: 2SPL Patentanwälte PartG mbB

(57) **Abstract**

A tuning cell for a digitally-controlled oscillator (DCO) core. The tuning cell may include a pair of capacitors differentially coupled to the DCO core in parallel, a switch coupled between the pair of capacitors in series and controlled by a control signal, and a biasing network configured to supply a bias voltage to internal nodes between each of the pair of capacitors and the switch, wherein the biasing network includes a diode or a transistor. The biasing network may include an anti-parallel diode. The tuning cell may include AC-coupling capacitors for coupling the internal nodes to a gate of the switch. The anti-parallel diode may include a pair of metal-oxide-semiconductor (MOS) diodes or transistors or PN junction diodes, coupled in parallel in opposite polarity.

## Description

### Field

Examples are related to a digitally-controlled oscillator (DCO), more particularly a tuning cell for capacitively tuning a DCO core.

### Background

DCOs are widely used nowadays. A DCO is an oscillator circuit that generates an oscillation signal in a frequency that is controlled by a digital control input. DCOs are typically tuned by switching capacitors in an LC tank to vary the oscillation frequency. A high quality factor (Q-factor), e.g. low on-resistance of the switches, and a high voltage swing is desired for good DCO phase noise (PN). Keeping the high voltage swing inside the switches within the reliability limits of the transistors is a critical part of the design. Therefore, the transistors are usually biased with a biasing resistor to ensure that their Vgs is below their threshold voltage at all times, thus they are turned off.

### Brief description of the Figures

Some examples of apparatuses and/or methods will be described in the following by way of example only, and with reference to the accompanying figures, in which
Fig. 1 is a schematic diagram of an example DCO core;
Fig. 2 shows an example tuning cell in a DCO core;
Fig. 3 shows the logic states of the two complementary control signals V_{ctrl} and V̅_̅{̅c̅t̅r̅l̅}̅ and the bias voltage V_{bias};
Figs. 4A and 4B show the internal waveforms of the tuning cell for the on and off states, respectively;
Fig. 5 shows an example structure of a tuning cell of a DCO core in accordance with one example;
Fig. 6A shows a biasing resistor as in Fig. 2;
Figs. 6B-6E show example configuration of the anti-parallel diodes (APDs);
Fig. 7 shows a tuning cell in a DCO in accordance with another example;
Fig. 8 shows waveforms at the internal node vₙ and at the gate of the transistor M₂ of the AC-coupled tuning cell in accordance with the above example;
Figs. 9A and 9B plot all transistor voltages for the switch transistor of the tuning cell in Fig. 2 and the AC-coupled tuning cell in Fig. 7, respectively;
Figs. 10A and 10B show Q-factor of the tuning cells in Fig. 2 and Fig. 7 for a control voltage normalized to the DCO V_{dd};
Fig. 11 shows a tuning cell in a DCO in accordance with another example;
Fig. 12 shows a tuning cell in a DCO in accordance with still another example;
Fig. 13 illustrates a user device in which the examples disclosed herein may be implemented; and
Fig. 14 illustrates a base station or infrastructure equipment radio head in which the examples disclosed herein may be implemented.

### Detailed Description

Various examples will now be described more fully with reference to the accompanying drawings in which some examples are illustrated. In the figures, the thicknesses of lines, layers and/or regions may be exaggerated for clarity.

Accordingly, while further examples are capable of various modifications and alternative forms, some particular examples thereof are shown in the figures and will subsequently be described in detail. However, this detailed description does not limit further examples to the particular forms described. Further examples may cover all modifications, equivalents, and alternatives falling within the scope of the disclosure. Like numbers refer to like or similar elements throughout the description of the figures, which may be implemented identically or in modified form when compared to one another while providing for the same or a similar functionality.

It will be understood that when an element is referred to as being "connected" or "coupled" to another element, the elements may be directly connected or coupled or via one or more intervening elements. If two elements A and B are combined using an "or", this is to be understood to disclose all possible combinations, i.e. only A, only B as well as A and B. An alternative wording for the same combinations is "at least one of A and B". The same applies for combinations of more than 2 elements.

The terminology used herein for the purpose of describing particular examples is not intended to be limiting for further examples. Whenever a singular form such as "a," "an" and "the" is used and using only a single element is neither explicitly or implicitly defined as being mandatory, further examples may also use plural elements to implement the same functionality. Likewise, when a functionality is subsequently described as being implemented using multiple elements, further examples may implement the same functionality using a single element or processing entity. It will be further understood that the terms "comprises," "comprising," "includes" and/or "including," when used, specify the presence of the stated features, integers, steps, operations, processes, acts, elements and/or components, but do not preclude the presence or addition of one or more other features, integers, steps, operations, processes, acts, elements, components and/or any group thereof.

Unless otherwise defined, all terms (including technical and scientific terms) are used herein in their ordinary meaning of the art to which the examples belong.

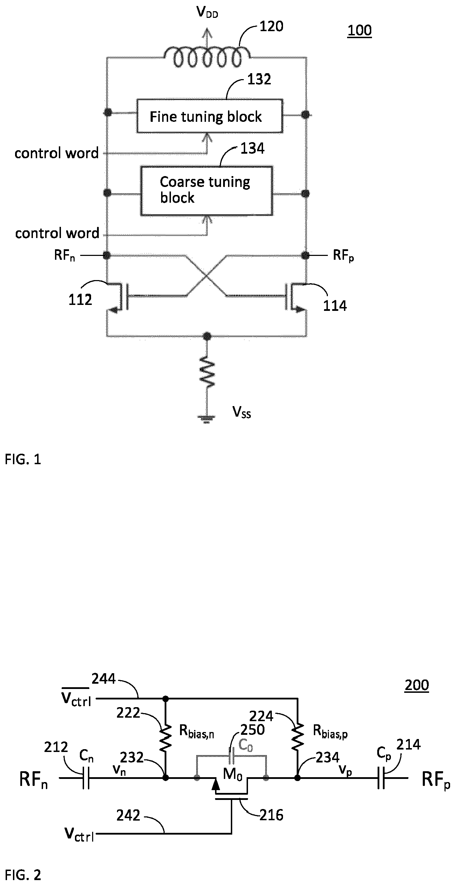

Fig. 1 is a schematic diagram of an example DCO core 100. The DCO core 100 may include a cross-coupled pair of transistors 112, 114, an inductor 120, and tuning blocks 132, 134 for capacitive tuning, that are coupled in parallel. The DCO core 100 may include several tuning blocks 132, 134 for coarse and fine tuning. The tuning blocks 132, 134 include a plurality of tuning cells and frequency tuning of the DCO core is performed by turning on and off the tuning cells in the tuning blocks with a control word.

Fig. 2 shows an example tuning cell 200 in a DCO core. The tuning cell 200 includes two identical capacitors Cₙ and Cₚ 212, 214 that are connected in series via a transistor M₀ 216 therebetween. The transistor M₀ 216 is a switch controlled by the control voltage V_{ctrl} 242. Depending on the on/off (closed/open) states of the transistor M₀ 216, the capacitors Cₙ and Cₚ 212, 214 are either differentially connected to the DCO core (RFₙ/RFₚ) or floating in the LC tank of the DCO core. The capacitor C₀ 250 is optional and will be discussed below. A bias voltage V_{bias} is supplied to the internal nodes vₙ and vₚ 232, 234 from the inverse of the control voltage V̅_̅{̅c̅t̅r̅l̅}̅ 244 via bias resistors R_{bias,n} and R_{bias,p} 222, 224, respectively.

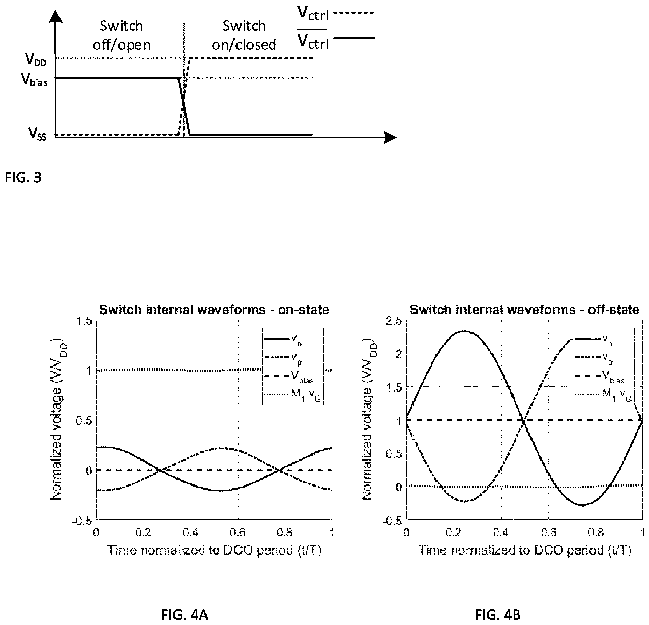

The logic states of the two complementary control signals V_{ctrl} and V̅_̅{̅c̅t̅r̅l̅}̅ and the bias voltage V_{bias} are shown in Fig. 3. When V_{ctrl} is pulled low (e.g. V_{SS}), the transistor 216 is open and the internal nodes vₙ and vₚ 232, 234 are biased with V_{bias} through V̅_̅{̅c̅t̅r̅l̅}̅. V_{bias} can be same as, or lower or higher than, V_{DD}. When the control voltage V_{ctrl} 242 is pulled high (e.g. V_{DD}), the transistor 216 is closed and the internal nodes vₙ and vₚ 232, 234 are biased with V_{SS} through V̅_̅{̅c̅t̅r̅l̅}̅. The internal waveforms of the tuning cell 200 for the on and off states are shown in Figs. 4A and 4B, respectively. In Figs. 4A and 4B, Vbias = V_{DD} and the values are normalized to V_{DD}.

During the on (closed) state of the switch (the transistor 216), the internal nodes vₙ and vₚ 232, 234 are coupled through the low resistance Rₒₙ of the transistor 216. As both vₙ and vₚ 232, 234 are further coupled to RFₙ and RFₚ by the capacitors Cₙ and Cₚ 212, 214, respectively, and to the V_{SS} through the bias resistors R_{bias,n} and R_{bias,p} 222, 224, respectively, the voltages at both vₙ and vₚ 232, 234 are approximately V_{SS} during the whole RF period.

During the off (open) state of the switch (the transistor 216), the internal nodes vₙ and vₚ 232, 234 are coupled through the high resistance R_{off} of the transistor 216. Due to the AC coupling via the capacitors Cₙ and Cₚ 212, 214 to RFₙ and RFₚ, respectively, the internal nodes vₙ and vₚ 232, 234 show approximately the same voltage swing as the RF signals RFₙ and RFₚ, respectively. As the internal nodes vₙ and vₚ 232, 234 are also coupled to V_{bias} via the bias resistors R_{bias,n} and R_{bias,p} 222, 224, respectively, the voltage swing at the internal nodes vₙ and vₚ 232, 234 is centered around V_{bias} (as shown in Fig. 4B). This biasing is necessary to prevent the voltage (V_{ctrl} - v_{n/p}) = - v_{n/p} in the off state of the switch from exceeding the threshold of the transistor 216, otherwise the switch could be closed and thus degrade the Q-factor in the off state. This happens if the internal nodes v_{n/p} 232, 234 swing into the negative domain, caused by too low biasing voltage.

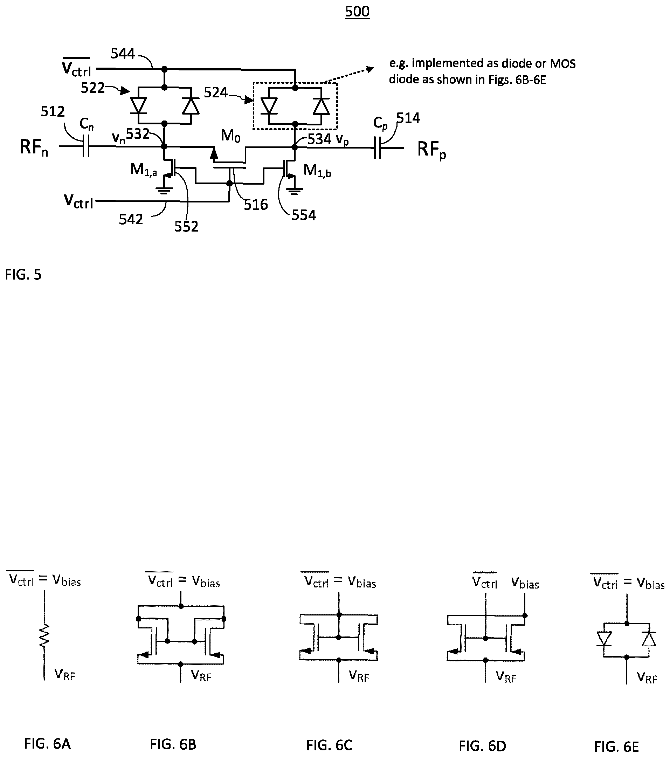

Fig. 5 shows an example structure of a tuning cell 500 of a DCO core in accordance with one example. The tuning cell 500 includes two capacitors Cₙ and Cₚ 512, 514 that are connected in series via a transistor M₀ 516 therebetween. The transistor M₀ 516 (e.g. an n-channel metal oxide semiconductor (n-MOS) transistor) is a switch controlled by the control voltage V_{ctrl} 542. Depending on the on/off (closed/open) states of the transistor 516, the capacitors Cₙ and Cₚ 512, 514 are either differentially connected to the DCO core (RFₙ/RFₚ) or floating in the LC tank of the DCO core. The tuning cell 500 includes a biasing network to supply bias voltages to the internal nodes vₙ and vₚ 532, 534. The biasing network may include a diode or a transistor instead of a resistor. For example, the biasing network may include anti-parallel diodes (APDs) 522, 524 and pull-down transistors 552, 554. The bias resistors R_{bias,n/p} 222, 224 in Fig. 2 may be replaced with the APDs 522, 524. APDs 522, 524 are diodes (or diode equivalents) connected in parallel in opposite polarity. The pull-down transistors 552, 554 (e.g. n-MOS transistor) pull down the internal node vₙ and vₚ 532, 534 to ground (V_{SS}) during the on state of the switch (the transistor 516).

When V_{ctrl} 542 is pulled high (e.g. supply voltage, V_{DD}), the transistor 516 is on and the internal nodes vₙ and vₚ 532, 534 are biased with V_{SS} through the biasing network including the APDs 522, 554 and the pull-down transistors M_{1,a/b} 552, 554. In the on-state of the switch, both sides of the APDs 522, 524 are at V_{SS}, as V̅_̅{̅c̅t̅r̅l̅}̅ = Vₛₛ and as the pull-down transistors M_{1,a/b} 552, 554 pull down the internal nodes vₙ and vₚ 532, 534 to V_{SS}. Then the APDs 522, 524 have no impact on the switch besides adding parasitic capacitance.

When V_{ctrl} 542 is pulled low (e.g. Vss), the transistor 516 is off. In the off state of the switch, the internal nodes vₙ and vₚ 532, 534 show the RF swing and are biased through V̅_̅{̅c̅t̅r̅l̅}̅ 544 (V̅_̅{̅c̅t̅r̅l̅}̅ = V_{bias}). During the oscillation period, the APDs 522, 524 charge the internal nodes vₙ and vₚ 532, 534 if the voltage at vₙ and vₚ is smaller than V_{bias} and discharge the internal nodes vₙ and vₚ 532, 534 if the voltage at vₙ and vₚ 532, 534 is larger than V_{bias}, converging to a steady state with a voltage swing around V_{bias} at vₙ and vₚ 532, 534, i.e. a biased AC signal as in Fig. 2.

Figs. 6B-6E show some example configuration of the APDs 522, 524. Fig. 6A shows a biasing resistor as in Fig. 2. Fig. 6B shows an APD implemented with metal-oxide-semiconductor (MOS) diodes. A MOS diode is a MOS transistor with gate and drain connected. The example APD in Fig. 6B includes one p-channel MOS (p-MOS) diode and one n-MOS diode coupled in parallel in opposite polarity. The control voltage/bias voltage (V̅_̅{̅c̅t̅r̅l̅}̅ = V_{bias}) is applied to the drains and gates of the transistors. Fig. 6C is a simplified version of Fig. 6B.

Fig. 6D shows an APD with separate control and bias voltage inputs. In this case, the control signal V̅_̅{̅c̅t̅r̅l̅}̅ and the bias voltage V_{bias} are separated. One n-MOS transistor and one p-MOS transistor are coupled in parallel and the inverse of the control voltage (V̅_̅{̅c̅t̅r̅l̅}̅) is applied to the gates of the transistors and the bias voltage (V_{bias}) is applied to the drains of the transistors. This would require an additional input pin for V_{bias}. The configuration shown in Fig. 6D is not a true MOS diode configuration since the drain and gate of the transistors are not connected but the transistors behave like a diode. The term "APD" is used to cover this structure as well.

Alternatively, the APD may be implemented with PN junction diodes as shown in Fig. 6E. Two PN junction diodes are coupled in parallel in opposite polarity.

In accordance with the examples above, the AC-biasing resistors 222, 224 are replaced with the anti-parallel diodes 522, 524 (or equivalents). This scheme optimizes the implementation of the AC-biasing, using only diode or transistor devices with lower area and better technology scalability. With this scheme, a significant area needed to implement high-ohmic bias resistors can be avoided. In accordance with the examples, large biasing resistors may be replaced with small APDs. This is especially effective for small switched capacitors where usually large resistors are placed.

Large voltage swings may be applied across the APDs. In such case, in order to limit the voltage applied across the diode or transistor and to increase the impedance of the APD, multiple diodes or transistors may be coupled in series in each branch of the APDs.

If DCOs have a high voltage swing that exceeds the reliability limits of a thin-oxide transistor of the switch (e.g. the transistor 516), the switch transistor needs to be implemented as a thick-oxide device to comply with the reliability limits. The drawbacks of using a thick oxide device are a longer channel length than a thin-oxide device, thus worse Rₒₙ, a larger area, and a larger control voltage at the gate of the switch transistor. The limiting factor from reliability point of view is V_{GD}/V_{GS} of the switch transistor. One known solution to this problem is the additional capacitor C₀ 250 that is added in parallel to the switch transistor M₀ 216 as shown in Fig. 2. The capacitor C₀ 250 has no impact on the switch in the on state, as it is shorted by the switch transistor M₀ 216. However, in the off state, the capacitor C₀ 250 implements a capacitive voltage divider in series with Cₙ and Cₚ 212, 214, reducing the AC swing of the internal nodes vₙ and vₚ 232, 234 to keep the switch transistor 216 in its reliable voltage limits. The major drawback of this scheme is the reduced Cₒₙ/C_{off} ratio of the overall switch. Thus, it severely affects the DCO frequency tuning range and cannot be implemented in all cases.

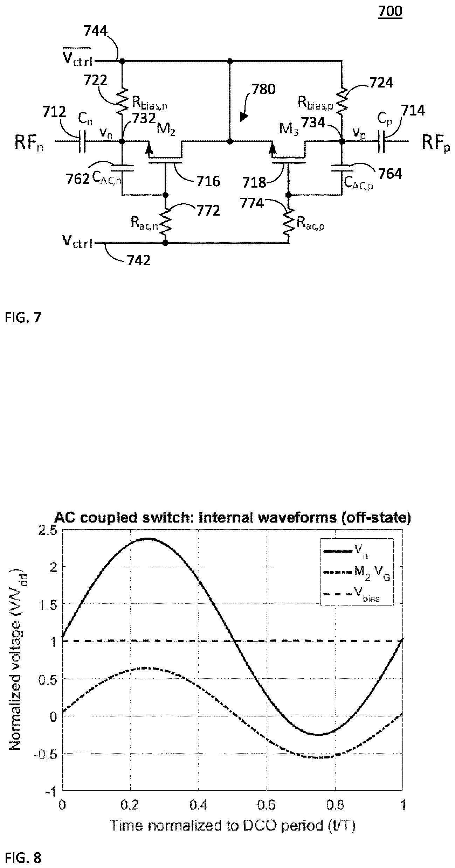

Fig. 7 shows a tuning cell 700 in a DCO in accordance with another example. The structure of the tuning cell 700 can alleviate the reliability critical voltages across the switch transistor without reducing the Cₒₙ/C_{off} ratio. The tuning cell 700 includes two capacitors Cₙ and Cₚ 712, 714 that are connected in series via transistors M₂ and M₃ 716, 718 therebetween. The transistors M₂ and M₃ 716, 718 are switches controlled by the control voltage V_{ctrl} 742. Depending on the on/off (closed/open) states of the switches, i.e. the transistors M₂ and M₃ 716, 718, the capacitors Cₙ and Cₚ 712, 714 are either differentially connected to the DCO core (RFₙ/RFₚ) or floating in the LC tank of the DCO core. The transistor M₀ 216 from Fig. 2 is split to two devices M₂ and M₃ 716, 718. The control signals 742 to the transistors M₂ and M₃ 716, 718 are the same, but the gates of the transistors M₂ and M₃ 716, 718 are de-coupled by resistors R_{ac,n} and R_{ac,p} 772, 774.

In one example, AC-coupling capacitors C_{AC,n} and C_{AC,p} 762, 764 may be provided to couple the internal nodes vₙ and vₚ 732, 734 to the gates of the transistors M₂ and M₃ 716, 718, respectively. During the off state of the switch (i.e. the transistors 716, 718), the internal nodes vₙ and vₚ 732, 734 are coupled through the high resistance R_{off} of the transistors 716, 718. Due to the AC coupling via the capacitors Cₙ and Cₚ 712, 714 to RFₙ and RFₚ, respectively, the internal nodes vₙ and vₚ 732, 734 show approximately the same voltage swing as the RF signals RFₙ and RFₚ, respectively. As the internal nodes vₙ and vₚ 732, 734 are also coupled to V_{bias} (= V̅_̅{̅c̅t̅r̅l̅}̅) via the bias resistors R_{bias,n} and R_{bias,p} 722, 724, respectively, the voltage swing at the internal nodes vₙ and vₚ 732, 734 is centered around V_{bias}.

As the internal nodes vₙ and vₚ 732, 734 are AC-coupled to the gates of the transistors M₂ and M₃ 716, 718 by the AC-coupling capacitors C_{AC,n} and C_{AC,p} 762, 764 in combination with the resistors R_{ac,n} and R_{ac,p} 772, 774, respectively, an AC swing appears at the gates of the transistors M₂ and M₃ 716, 718 that is in phase with the respective internal node vₙ and vₚ 732, 734. This results in a reduced voltage difference between the internal nodes vₙ and vₚ 732, 734 and the control gate of the transistors M₂ and M₃ 716, 718. Therefore, the reliability critical voltages across the gate and source/drain of the transistors M₂ and M₃ 716, 718 are reduced. This allows using thin-oxide transistors as a switch (the transistors 716, 718) even for large DCO amplitudes.

During the on state of the switch (i.e. the transistors 716, 718), the voltages at the internal nodes vₙ and vₚ 732, 734 and V̅_̅{̅c̅t̅r̅l̅}̅ are approximately at V_{SS}, thus the circuit behaves as a regular switch. By replacing the transistor M0 216 in Fig. 2, which needs to be implemented as a thick-oxide device due to reliability reasons, with two (or more) transistors M2 and M3 716, 718, which may be implemented as a thin-oxide device, the combined channel length of the devices can be shorter than a single thick-oxide device, leading to a lower on-resistance and thus a better Q-factor of the tuning cell.

In one example, the AC-coupling capacitors C_{AC,n} and C_{AC,p} 762, 764 may be implemented with discrete capacitors. Alternatively, the AC-coupling capacitors C_{AC,n} and C_{AC,p} 762, 764 may be parasitic capacitances of the switch transistors M₂ and M₃ 716, 718. For sufficiently large transistors the parasitic capacitance of the transistors M₂ and M₃ 716, 718 may provide sufficient coupling between the internal nodes vₙ and vₚ 732, 734 and the gate of the transistors M₂ and M₃ 716, 718.

The voltage across the drain and the source of the transistors M₂ and M₃ 716, 718 may be kept in a reliable state by a biasing the network 780 between the transistors M₂ and M₃ 716, 718 to V_{bias} in the off state and to Vₛₛ in the on state. As the circuit may ensure that the switches (the transistors 716, 718) are both closed during the off state, a short to V̅_̅{̅c̅t̅r̅l̅}̅ (as shown in Fig. 7) may be sufficient to implement the wanted behavior, as no current is flowing through it. Alternatively, as this is a DC coupling, a biasing resistor may be used. A biasing resistor may be placed instead of a short. Alternatively, it may be open.

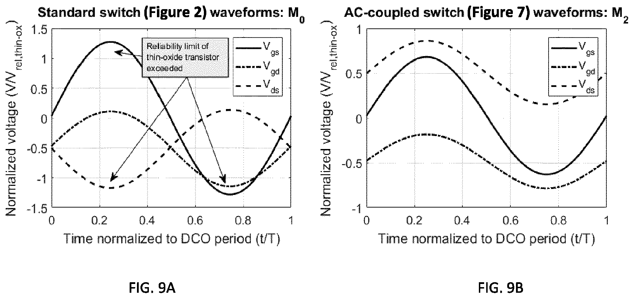

Fig. 8 shows waveforms at the internal node vₙ 732 and at the gate of the transistor M₂ 716 of the AC-coupled tuning cell 700 in accordance with the above example. Fig. 8 shows that the AC swing at the gate of the transistor M₂ 716 is reduced significantly compared to vₙ. The AC swing at the gate of the transistor M₂ 716 is in phase to vₙ and stays below vₙ, which ensures that the transistor 716 is always turned off in the off state. To reference this to the voltage reliability limit of the thin-oxide devices V_{rel_thin-ox}, Figs. 9A and 9B plot all transistor voltages for the switch transistor of the tuning cell 200 in Fig. 2 and the AC-coupled tuning cell 700 in Fig. 7, respectively. Fig. 9A shows the reliability issue of the tuning cell 200 in Fig. 2 in the off state of the transistor 216, where thick-oxide transistors are needed to cope with the reliability relevant voltage swing of up to ∼1.3 V_{rel_thin-ox}. As shown in Fig. 9A, the tuning cell 200 in Fig. 2 fails the reliability requirements. In contrast, Fig. 9B shows that the signal levels of the AC-coupled tuning cell 700 in Fig. 7 stays clearly below this limit, especially the gate-oxide-breakdown relevant voltages V_{gs} and V_{gd}. Fig. 9B shows that the AC-coupled tuning cell allows the usage of thin-oxide devices with sufficient headroom.

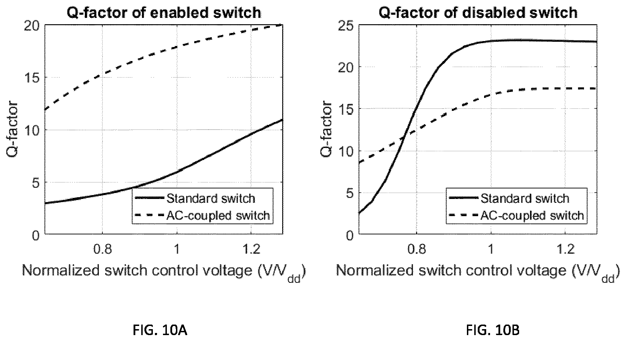

Figs. 10A and 10B show Q-factor of the tuning cells (switches) in Fig. 2 and Fig. 7 for a control voltage normalized to the DCO V_{dd}. The plots in Figs. 10A and 10B are provided as an example for comparison and the numbers shown in the figures may be different depending on technology, topology, etc. Fig. 10A shows that the Q-factor increases significantly for an on-state switch, and Fig. 10B shows still excellent values for an off-state switch. The tuning cell 200 in Fig. 2 needs a higher control voltage than the DCO V_{dd}, thus an extra low dropout regulator (LDO) is needed to achieve a Q-factor of ∼11. The AC-coupled tuning cell 700 in Fig. 7 achieves with the DCO V_{dd} a much better Q-factor of ∼18, thus the extra LDO can be removed from the system. For an off-state switch (shown in Fig. 10B) the Q-factor is still excellent, as C_{off} is relatively small compared to Cₒₙ. The off-case Q-factor is, however, not as critical as in the on case. Further improvements include a reduced control voltage, an improvement in Cₒₙ/C_{off} ratio by >20%, improved reliability, smaller supply voltage (one LDO could be completely removed), and smaller area.

The AC-coupling of the switch control terminal may reduce the reliability critical voltage swing across the switch transistor in the off state. Especially this allows to replace the thick oxide switch transistors with poor on-resistance by thin oxide transistors with good on-resistance. With this scheme, a better Q-factor may be achieved, which significantly improves a phase noise due to lower on-resistance of the thin oxide compared to thick oxide devices, and a smaller transistor area (which dominates the switch area and the Cₒₙ/C_{off} ratio) and a lower control voltage may be used.

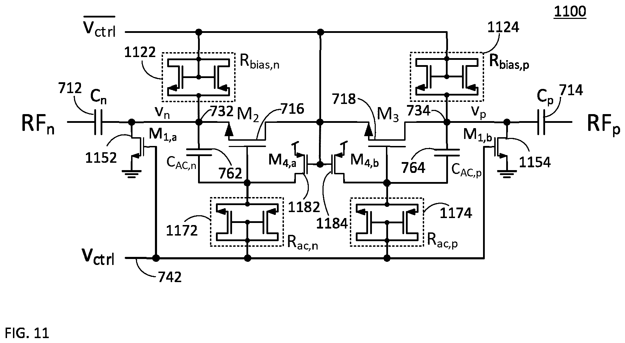

Fig. 11 shows a tuning cell 1100 in a DCO in accordance with another example. In this example, the resistors in the tuning cell 700 in Fig. 7 may be replaced with APDs as in the tuning cell 500 in Fig. 5. This example is a combination of the schemes in Figs. 5 and 7. Each of the biasing resistors R_{bias,p} and R_{bias,p} 722, 724 in Fig. 7 may be replaced with an APD 1122, 1124 and a pull-down transistor 1152, 1154, respectively. Each of the resistors 772, 774 in Fig. 7 may be replaced with an APD 1172, 1174 and a pull-up transistor 1182, 1184 (e.g. a p-MOS).

The tuning cell 1100 includes two capacitors Cₙ and Cₚ 712, 714 that are connected in series via transistors M₂ and M₃ 716, 718 therebetween. The transistors M₂ and M₃ 716, 718 are switches controlled by the control voltage V_{ctrl} 742. Depending on the on/off (closed/open) states of the switches, (i.e. the transistors M₂ and M₃ 716, 718), the capacitors Cₙ and Cₚ 712, 714 are either differentially connected to the DCO core (RFₙ/RFₚ) or floating in the LC tank of the DCO core.

The tuning cell 1100 includes a biasing network to supply bias voltages to the internal nodes vₙ and vₚ 732, 734. The biasing network may include a diode or a transistor instead of a resistor. For example, the biasing network may include APDs 1122, 1124 and pull-down transistors 1152, 1154. The pull-down transistors 1152, 1154 (e.g. n-MOS transistor) pull down the internal node vₙ and vₚ 732, 734 to V_{SS} during the on state of the switch (the transistors 716, 718).

When V_{ctrl} 742 is pulled high (e.g. V_{DD}), the transistors 716, 718 are on and the internal nodes vₙ and vₚ 732, 734 are biased with V_{SS} through V̅_̅{̅c̅t̅r̅l̅}̅. In the on-state of the switch, both sides of the APDs 1122, 1124 are at V_{SS}, as V̅_̅{̅c̅t̅r̅l̅}̅ = Vₛₛ and as the pull-down transistors M_{1,a/b} 1152, 1154 pull down the internal nodes vₙ and vₚ 732, 734 to V_{SS}. Then the APDs 1122, 1124 have no impact on the switch besides adding parasitic capacitance.

When V_{ctrl} 742 is pulled low (e.g. Vss), the transistors 716, 718 are off. In the off state of the switch, the internal nodes vₙ and vₚ 732, 734 show the RF swing and the bias through V̅_̅{̅c̅t̅r̅l̅}̅ (V̅_̅{̅c̅t̅r̅l̅}̅ = V_{bias}). During the oscillation period, the APDs 1122, 1124 charge the internal nodes vₙ and vₚ 732, 734 if the voltage at vₙ and vₚ is smaller than V_{bias} and discharge the internal nodes vₙ and vₚ 732, 734 if the voltage at vₙ and vₚ 732, 734 is larger than V_{bias}, converging to a steady state with a voltage swing around V_{bias} at vₙ and vₚ 732, 734.

The AC-coupling capacitors C_{AC,n} and C_{AC,p} 762, 764 couple the internal nodes vₙ and vₚ 732, 734 to the gates of the transistors M₂ and M₃ 716, 718, respectively. During the on state of the switch (i.e. the transistors 716, 718), the voltages at the internal nodes vₙ and vₚ 732, 734 and V̅_̅{̅c̅t̅r̅l̅}̅ are approximately at V_{SS}, thus the circuit behaves as a regular switch.

During the off state of the switch, the internal nodes vₙ and vₚ 732, 734 are coupled through the high resistance R_{off} of the transistors 716, 718. Due to the AC coupling via the capacitors Cₙ and Cₚ 712, 714 to RFₙ and RFₚ, respectively, the internal nodes vₙ and vₚ 732, 734 show approximately the same voltage swing as the RF signals RFₙ and RFₚ, respectively. As the internal nodes vₙ and vₚ 732, 734 are also coupled to V_{bias} via the APDs 1122, 1124, respectively, the voltage swing at the internal nodes vₙ and vₚ 732, 734 is centered around V_{bias}.

As the internal nodes vₙ and vₚ 732, 734 are AC-coupled to the gates of the transistors M₂ and M₃ 716, 718 by the AC-coupling capacitors C_{AC,n} and C_{AC,p} 762, 764 in combination with the APDs 1172, 1174, respectively, an AC swing appears at the gates of the transistors M₂ and M₃ 716, 718 in the off state of the transistors M₂ and M₃ 716, 718 that is in phase with the respective internal node vₙ and vₚ 732, 734. This results in a reduced voltage difference between the internal nodes vₙ and vₚ 732, 734 and the control gate of the transistors M₂ and M₃ 716, 718. Therefore, the reliability critical voltages across the gate and source/drain of the transistors M₂ and M₃ 716, 718 are reduced. This allows using thin-oxide transistors as a switch (the transistors 716, 718) even for large DCO amplitudes.

The APDs 1172, 1174 bias the gates of the transistors M₂ and M₃ 716, 718 to Vₛₛ in the off state, while the pull-up transistors M_{4,a} and M_{4,b} (e.g. p-MOS transistors) 1182, 1184 pull the gates of the transistors M₂ and M₃ 716, 718 to V_{DD} in the on state. This measure not only replaces the area hungry resistors, but also provides additionally a low-ohmic connection to the gates of the transistors M₂ and M₃ 716, 718 in the on state (which is coupled to the control signal via R_{ac,n/p} in Fig. 7).

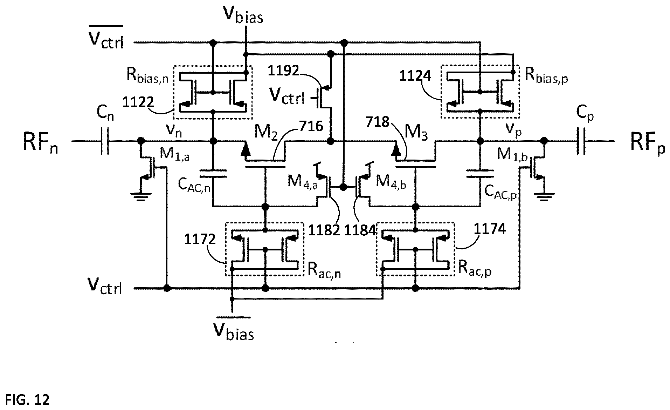

Fig. 12 shows a tuning cell in a DCO in accordance with still another example. The examples disclosed above assume that V̅_̅{̅c̅t̅r̅l̅}̅ = V_{bias}. In case V̅_̅{̅c̅t̅r̅l̅}̅ ≠ V_{bias} the following changes need to be applied, as shown in Fig. 12: 1) the APD structure 1122, 1124, 1172, 1174 may be replaced by the structure shown in Fig. 6D, 2) the gates of the pull-up transistors M_{4,a} and M_{4,b} 1182, 1184 may be connected to V̅_̅{̅c̅t̅r̅l̅}̅, and 3) the short of the net connecting the transistors M₂ and M₃ 716, 718 may be replaced by a transistor switch 1192 (e.g. p-MOS) with a control gate connected to V_{ctrl} and the source connected to V_{bias} (connecting the gate to V_{bias} in the off state and leaving it floating in the on state). In Fig. 12, V̅_̅{̅b̅i̅a̅s̅}̅ may be Vₛₛ or may be set to a different voltage (different than Vₛₛ).

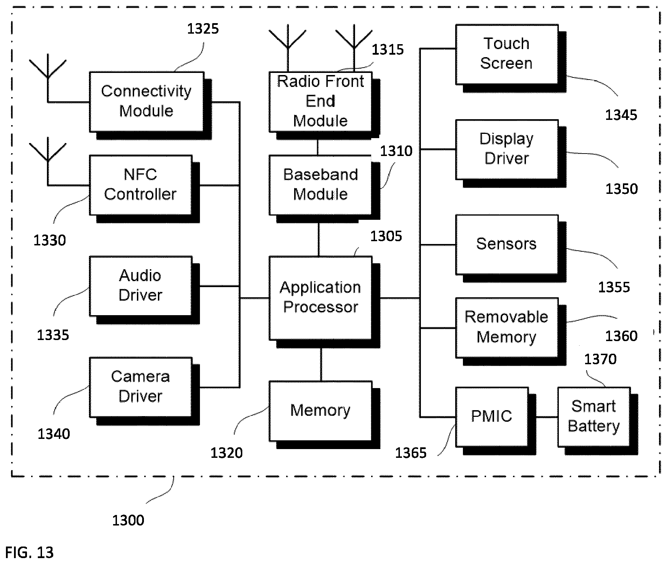

Fig. 13 illustrates a user device 1300 in which the examples disclosed herein may be implemented. The user device 1300 may be a mobile device in some aspects and includes an application processor 1305, baseband processor 1310 (also referred to as a baseband module), radio front end module (RFEM) 1315, memory 1320, connectivity module 1325, near field communication (NFC) controller 1330, audio driver 1335, camera driver 1340, touch screen 1345, display driver 1350, sensors 1355, removable memory 1360, power management integrated circuit (PMIC) 1365 and smart battery 1370.

In some aspects, application processor 1305 may include, for example, one or more CPU cores and one or more of cache memory, low drop-out voltage regulators (LDOs), interrupt controllers, serial interfaces such as serial peripheral interface (SPI), inter-integrated circuit (I²C) or universal programmable serial interface module, real time clock (RTC), timer-counters including interval and watchdog timers, general purpose input-output (IO), memory card controllers such as secure digital / multi-media card (SD/MMC) or similar, universal serial bus (USB) interfaces, mobile industry processor interface (MIPI) interfaces and Joint Test Access Group (JTAG) test access ports.

In some aspects, baseband module 1310 may be implemented, for example, as a solder-down substrate including one or more integrated circuits, a single packaged integrated circuit soldered to a main circuit board, and/or a multi-chip module containing two or more integrated circuits.

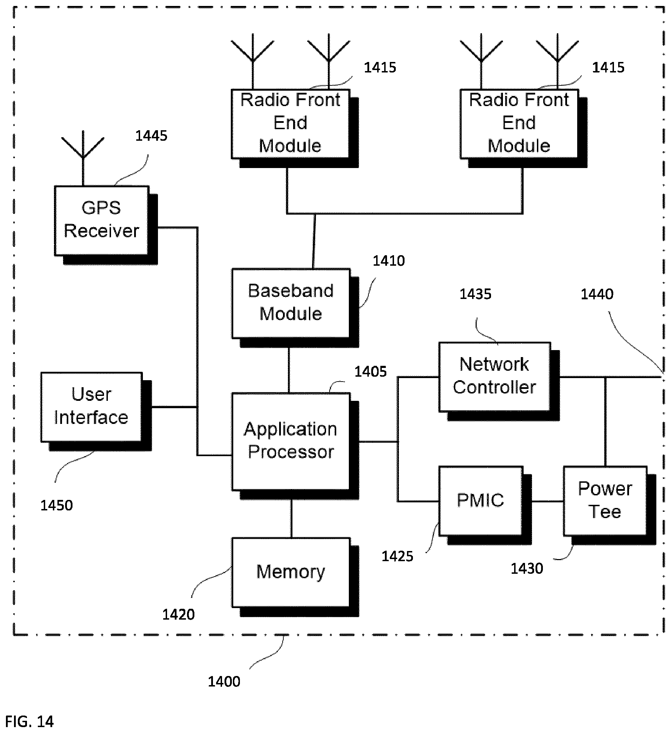

Fig. 14 illustrates a base station or infrastructure equipment radio head 1400 in which the examples disclosed herein may be implemented. The base station radio head 1400 may include one or more of application processor 1405, baseband modules 1410, one or more radio front end modules 1415, memory 1420, power management circuitry 1425, power tee circuitry 1430, network controller 1435, network interface connector 1440, satellite navigation receiver module 1445, and user interface 1450.

In some aspects, application processor 1405 may include one or more CPU cores and one or more of cache memory, low drop-out voltage regulators (LDOs), interrupt controllers, serial interfaces such as SPI, I²C or universal programmable serial interface module, real time clock (RTC), timer-counters including interval and watchdog timers, general purpose IO, memory card controllers such as SD/MMC or similar, USB interfaces, MIPI interfaces and Joint Test Access Group (JTAG) test access ports.

In some aspects, baseband processor 1410 may be implemented, for example, as a solder-down substrate including one or more integrated circuits, a single packaged integrated circuit soldered to a main circuit board or a multi-chip module containing two or more integrated circuits.

In some aspects, memory 1420 may include one or more of volatile memory including dynamic random access memory (DRAM) and/or synchronous dynamic random access memory (SDRAM), and nonvolatile memory (NVM) including high-speed electrically erasable memory (commonly referred to as Flash memory), phase change random access memory (PRAM), magneto resistive random access memory (MRAM) and/or a three-dimensional crosspoint memory. Memory 1420 may be implemented as one or more of solder down packaged integrated circuits, socketed memory modules and plug-in memory cards.

In some aspects, power management integrated circuitry 1425 may include one or more of voltage regulators, surge protectors, power alarm detection circuitry and one or more backup power sources such as a battery or capacitor. Power alarm detection circuitry may detect one or more of brown out (under-voltage) and surge (over-voltage) conditions.

In some aspects, power tee circuitry 1430 may provide for electrical power drawn from a network cable to provide both power supply and data connectivity to the base station radio head 1400 using a single cable.

In some aspects, network controller 1435 may provide connectivity to a network using a standard network interface protocol such as Ethernet. Network connectivity may be provided using a physical connection which is one of electrical (commonly referred to as copper interconnect), optical or wireless.

In some aspects, satellite navigation receiver module 1445 may include circuitry to receive and decode signals transmitted by one or more navigation satellite constellations such as the global positioning system (GPS), Globalnaya Navigatsionnaya Sputnikovaya Sistema (GLONASS), Galileo and/or BeiDou. The receiver 1445 may provide data to application processor 1405 which may include one or more of position data or time data. Application processor 1405 may use time data to synchronize operations with other radio base stations.

In some aspects, user interface 1450 may include one or more of physical or virtual buttons, such as a reset button, one or more indicators such as light emitting diodes (LEDs) and a display screen.

Another example is a computer program having a program code for performing at least one of the methods described herein, when the computer program is executed on a computer, a processor, or a programmable hardware component. Another example is a machine-readable storage including machine readable instructions, when executed, to implement a method or realize an apparatus as described herein. A further example is a machine-readable medium including code, when executed, to cause a machine to perform any of the methods described herein.

The examples as described herein may be summarized as follows:
Example 1 is a tuning cell for a DCO core. The tuning cell includes a pair of capacitors differentially coupled to the DCO core in parallel, a switch coupled between the pair of capacitors in series and controlled by a control signal, and a biasing network configured to supply a bias voltage to internal nodes between each of the pair of capacitors and the switch, wherein the biasing network includes a diode or a transistor.
Example 2 is the tuning cell of example 1, wherein the biasing network includes an anti-parallel diode configured to supply the bias voltage to the internal nodes during an off state of the switch and a pull-down transistor configured to pull down the internal nodes to ground during an on state of the switch.
Example 3 is the tuning cell of example 2, wherein the anti-parallel diode comprises a pair of MOS diodes coupled in parallel in opposite polarity.
Example 4 is the tuning cell of example 3, wherein the control signal and the bias voltage are provided separately to the anti-parallel diode.
Example 5 is the tuning cell of example 2, wherein the anti-parallel diode comprises a pair of PN junction diodes coupled in parallel in opposite polarity.
Example 6 is a tuning cell for a DCO core. The tuning cell includes a first capacitor and a second capacitor that are differentially coupled to the DCO core in parallel, a first switch transistor and a second switch transistor that are coupled between the first capacitor and the second capacitor in series and controlled by a control signal, a biasing network configured to supply a bias voltage to a first internal node between the first capacitor and the first switch transistor and to a second internal node between the second capacitor and the second switch transistor, and a first AC-coupling capacitor for coupling the first internal node to a gate of the first switch transistor and a second AC-coupling capacitor for coupling the second internal node to a gate of the second switch transistor.
Example 7 is the tuning cell of example 6, wherein the first AC-coupling capacitor and the second AC-coupling capacitor are discrete capacitors.
Example 8 is the tuning cell of example 6, wherein the first AC-coupling capacitor and the second AC-coupling capacitor are parasitic capacitances of the first switch transistor and the second switch transistor, respectively.
Example 9 is the tuning cell as in any one of examples 6-8, wherein each of the first switch transistor and the second switch transistor is coupled to the control signal via a separate resistor.
Example 10 is the tuning cell as in any one of examples 6-8, wherein each of the first switch transistor and the second switch transistor is coupled to the control signal via an anti-parallel diode.
Example 11 is the tuning cell of example 10, further comprising a first pull-up transistor and a second pull-up transistor configured to supply a supply voltage to the gate of the first switch transistor and the second switch transistor, respectively, when the first switch transistor and the second switch transistor are on.
Example 12 is the tuning cell as in any one of examples 6-11, wherein the biasing network includes a diode or a transistor.
Example 13 is the tuning cell of example 12, wherein the biasing network includes an anti-parallel diode configured to supply the bias voltage to the first internal node and the second internal node during an off state of the first switch transistor and the second switch transistor and a first pull-down transistor and a second pull-down transistor configured to pull down the first internal node and the second internal node to ground, respectively, during an on state of the first switch transistor and the second switch transistor.
Example 14 is the tuning cell of example 13, wherein the anti-parallel diode comprises a pair of MOS diodes coupled in parallel in opposite polarity or a pair of PN junction diodes coupled in parallel in opposite polarity.
Example 15 is the tuning cell of example 14, wherein the control signal and the bias voltage are provided separately to the anti-parallel diode.
Example 16 is the tuning cell as in any one of examples 6-15, further comprising a second biasing network for DC coupling a node between the first and second transistors to the bias voltage in an off state of the first switch transistor and the second switch transistor and to ground in an on state of the first switch transistor and the second switch transistor, wherein the second biasing network is short or resistive coupling, or open.

The aspects and features mentioned and described together with one or more of the previously detailed examples and figures, may as well be combined with one or more of the other examples in order to replace a like feature of the other example or in order to additionally introduce the feature to the other example.

Examples may further be or relate to a computer program having a program code for performing one or more of the above methods, when the computer program is executed on a computer or processor. Steps, operations or processes of various above-described methods may be performed by programmed computers or processors. Examples may also cover program storage devices such as digital data storage media, which are machine, processor or computer readable and encode machine-executable, processor-executable or computer-executable programs of instructions. The instructions perform or cause performing some or all of the acts of the above-described methods. The program storage devices may comprise or be, for instance, digital memories, magnetic storage media such as magnetic disks and magnetic tapes, hard drives, or optically readable digital data storage media. Further examples may also cover computers, processors or control units programmed to perform the acts of the above-described methods or (field) programmable logic arrays ((F)PLAs) or (field) programmable gate arrays ((F)PGAs), programmed to perform the acts of the above-described methods.

The description and drawings merely illustrate the principles of the disclosure. Furthermore, all examples recited herein are principally intended expressly to be only for pedagogical purposes to aid the reader in understanding the principles of the disclosure and the concepts contributed by the inventor(s) to furthering the art. All statements herein reciting principles, aspects, and examples of the disclosure, as well as specific examples thereof, are intended to encompass equivalents thereof.

A functional block denoted as "means for ..." performing a certain function may refer to a circuit that is configured to perform a certain function. Hence, a "means for s.th." may be implemented as a "means configured to or suited for s.th.", such as a device or a circuit configured to or suited for the respective task.

Functions of various elements shown in the figures, including any functional blocks labeled as "means", "means for providing a sensor signal", "means for generating a transmit signal.", etc., may be implemented in the form of dedicated hardware, such as "a signal provider", "a signal processing unit", "a processor", "a controller", etc. as well as hardware capable of executing software in association with appropriate software. When provided by a processor, the functions may be provided by a single dedicated processor, by a single shared processor, or by a plurality of individual processors, some of which or all of which may be shared. However, the term "processor" or "controller" is by far not limited to hardware exclusively capable of executing software but may include digital signal processor (DSP) hardware, network processor, application specific integrated circuit (ASIC), field programmable gate array (FPGA), read only memory (ROM) for storing software, random access memory (RAM), and non-volatile storage. Other hardware, conventional and/or custom, may also be included.

A block diagram may, for instance, illustrate a high-level circuit diagram implementing the principles of the disclosure. Similarly, a flow chart, a flow diagram, a state transition diagram, a pseudo code, and the like may represent various processes, operations or steps, which may, for instance, be substantially represented in computer readable medium and so executed by a computer or processor, whether or not such computer or processor is explicitly shown. Methods disclosed in the specification or in the claims may be implemented by a device having means for performing each of the respective acts of these methods.

It is to be understood that the disclosure of multiple acts, processes, operations, steps or functions disclosed in the specification or claims may not be construed as to be within the specific order, unless explicitly or implicitly stated otherwise, for instance for technical reasons. Therefore, the disclosure of multiple acts or functions will not limit these to a particular order unless such acts or functions are not interchangeable for technical reasons. Furthermore, in some examples a single act, function, process, operation or step may include or may be broken into multiple sub-acts, -functions, -processes, -operations or -steps, respectively. Such sub acts may be included and part of the disclosure of this single act unless explicitly excluded.

Furthermore, the following claims are hereby incorporated into the detailed description, where each claim may stand on its own as a separate example. While each claim may stand on its own as a separate example, it is to be noted that - although a dependent claim may refer in the claims to a specific combination with one or more other claims - other examples may also include a combination of the dependent claim with the subject matter of each other dependent or independent claim. Such combinations are explicitly proposed herein unless it is stated that a specific combination is not intended. Furthermore, it is intended to include also features of a claim to any other independent claim even if this claim is not directly made dependent to the independent claim.

## Claims

1. A tuning cell (500) for a digitally-controlled oscillator, DCO, core, comprising:
a pair of capacitors (512, 514) differentially coupled to the DCO core in parallel;
a switch (516) coupled between the pair of capacitors (512, 514) in series and controlled by a control signal (542); and
a biasing network configured to supply a bias voltage to internal nodes between each of the pair of capacitors (512, 514) and the switch (516), wherein the biasing network includes a diode or a transistor.

2. The tuning cell (500) of claim 1, wherein the biasing network includes an anti-parallel diode (522, 524) configured to supply the bias voltage to the internal nodes during an off state of the switch (516) and a pull-down transistor (552, 554) configured to pull down the internal nodes to ground during an on state of the switch (516).

3. The tuning cell (500) of claim 2, wherein the anti-parallel diode (522, 524) comprises a pair of metal-oxide-semiconductor, MOS, diodes coupled in parallel in opposite polarity.

4. The tuning cell (500) of claim 3, wherein the control signal and the bias voltage are provided separately to the anti-parallel diode (522, 524).

5. The tuning cell (500) of claim 2, wherein the anti-parallel diode (522, 524) comprises a pair of PN junction diodes coupled in parallel in opposite polarity.

6. A tuning cell for a digitally-controlled oscillator, DCO, core, comprising:
a first capacitor (712) and a second capacitor (714) that are differentially coupled to the DCO core in parallel;
a first switch transistor (716) and a second switch transistor (718) that are coupled between the first capacitor (712) and the second capacitor (714) in series and controlled by a control signal (742);
a biasing network configured to supply a bias voltage to a first internal node between the first capacitor (712) and the first switch transistor (716) and to a second internal node between the second capacitor (714) and the second switch transistor (718); and
a first AC-coupling capacitor (762) for coupling the first internal node to a gate of the first switch transistor (716) and a second AC-coupling capacitor (764) for coupling the second internal node to a gate of the second switch transistor (718).

7. The tuning cell of claim 6, wherein the first AC-coupling capacitor (762) and the second AC-coupling capacitor (764) are discrete capacitors.

8. The tuning cell of claim 6, wherein the first AC-coupling capacitor (762) and the second AC-coupling capacitor (764) are parasitic capacitances of the first switch transistor (716) and the second switch transistor (718), respectively.

9. The tuning cell as in any one of claims 6-8, wherein each of the first switch transistor (716) and the second switch transistor (718) is coupled to the control signal (742) via a separate resistor (772, 774).

10. The tuning cell as in any one of claims 6-8, wherein each of the first switch transistor (716) and the second switch transistor (718) is coupled to the control signal (742) via an anti-parallel diode (1172, 1174).

11. The tuning cell of claim 10, further comprising a first pull-up transistor (1182) and a second pull-up transistor (1184) configured to supply a supply voltage to the gate of the first switch transistor (716) and the second switch transistor (718), respectively, when the first switch transistor (716) and the second switch transistor (718) are on.

12. The tuning cell as in any one of claims 6-11, wherein the biasing network includes a diode or a transistor.

13. The tuning cell of claim 12, wherein the biasing network includes an anti-parallel diode (1122, 1124) configured to supply the bias voltage to the first internal node and the second internal node during an off state of the first switch transistor (716) and the second switch transistor (718) and a first pull-down transistor (1152) and a second pull-down transistor (1154) configured to pull down the first internal node and the second internal node to ground, respectively, during an on state of the first switch transistor (716) and the second switch transistor (718).

14. The tuning cell of claim 13, wherein the anti-parallel diode (1122, 1124) comprises a pair of metal-oxide-semiconductor, MOS, diodes coupled in parallel in opposite polarity or a pair of PN junction diodes coupled in parallel in opposite polarity.

15. The tuning cell as in any one of claims 6-14, further comprising a second biasing network (780) for DC coupling a node between the first and second transistors (716, 718) to the bias voltage in an off state of the first switch transistor (716) and the second switch transistor (718) and to ground in an on state of the first switch transistor (716) and the second switch transistor (718), wherein the second biasing network (780) is short or resistive coupling, or open.
